(19) Europäisches Patentamt
European Patent Office
Office européen des brevets

(11) **EP 4 283 348 A1**

(12) **EUROPEAN PATENT APPLICATION**
published in accordance with Art. 153(4) EPC

(43) Date of publication:
**29.11.2023 Bulletin 2023/48**

(21) Application number: **21921114.1**

(22) Date of filing: **15.07.2021**

(51) International Patent Classification (IPC):
***G02B 5/22*** *(2006.01)* ***G02B 1/116*** *(2015.01)*
***G02B 1/16*** *(2015.01)* ***G02B 1/18*** *(2015.01)*
***G02B 5/02*** *(2006.01)* ***G02F 1/1335*** *(2006.01)*
***G09F 9/00*** *(2006.01)*

(52) Cooperative Patent Classification (CPC):
**G02B 1/116; G02B 1/16; G02B 1/18; G02B 5/02; G02B 5/22; G02F 1/1335; G09F 9/00**

(86) International application number:
**PCT/JP2021/026647**

(87) International publication number:
**WO 2022/158008 (28.07.2022 Gazette 2022/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.01.2021 JP 2021006750**

(71) Applicant: **TOPPAN INC.**
**Tokyo 110-0016 (JP)**

(72) Inventors:
- **ISHIMARU, Yoshiko**
  **Tokyo 110-0016 (JP)**
- **ISHIKAWA, Shinya**
  **Tokyo 110-0016 (JP)**

(74) Representative: **TBK**
**Bavariaring 4-6**
**80336 München (DE)**

# (54) OPTICAL SHEET AND DISPLAY DEVICE

(57) The optical sheet includes: a first adhesive layer containing an adhesive and a colorant, the first adhesive layer having opposite first and second surfaces; and an ultraviolet shielding layer arranged to face the first surface. The colorant contains at least one of a first coloring material having a maximum absorption wavelength in a range of 470 to 530 nm and an absorption spectral half width of 15 to 45 nm, a second coloring material having a maximum absorption wavelength in a range of 560 to 620 nm and an absorption spectral half width of 15 to 55 nm, and a third coloring material in which a wavelength having the lowest transmittance in a wavelength range of 400 to 800 nm is in a range of 650 to 800 nm. The ultraviolet shielding layer has an ultraviolet shielding rate of 85% or more. ΔE □ ab, which is a chromaticity difference between before and after a light resistance test (irradiation for 120 hours under the conditions of a xenon lamp illuminance of 60 W/cm$^2$ (300 to 400 nm), a temperature of 45°C, and a humidity of 50% RH), is 5 or less.

FIG.1

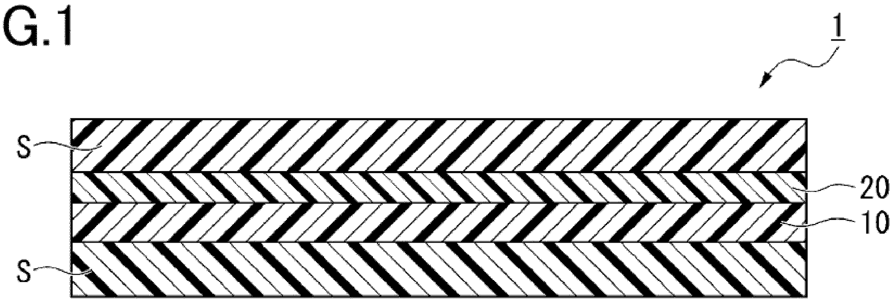


EP 4 283 348 A1

## Description

[Technical Field]

The present invention relates to an optical sheet and a display device.
The present application claims priority to Japanese Patent Application No. 2021-006750 filed January 19, 2021, the contents of which are incorporated herein by reference.

[Background Art]

To improve the color purity of a display device, there is a known method of using a color filter to separate or correct white light or monochromatic light emitted from a light source of a display device to narrow a full width at half maximum.
For improving color purity by a color filter, it is necessary to increase the concentration of a coloring material and thicken the filter. High coloring material concentrations, however, may degrade photolithographic properties. Thickening a filter may deteriorate pixel shapes and viewing angle properties.
Furthermore, a color filter which improved color purity is generally low in transmittance and likely to lower luminance efficiency.
In view of the above, a method of improving color purity without using a color filter is proposed.
PTL 1 discloses an optical filter including an adhesive resin layer that contains a coloring material having strong absorption of light in a prescribed wavelength band.

[Citation List]

[Patent Literature]

[PTL 1] JP 2019-56865 A
[PTL 2] JP 5917659 B

[Summary of the Invention]

[Technical Problem]

A functional colorant contained in a coloring material used in a color-correction layer is often not high in light resistance, heat resistance, and moist heat resistance. Therefore, in an optical filter including such a functional colorant, the function of the functional colorant may decrease with use, leading to a failure to sufficiently exert the color correction function.
PTL 2 discloses a technique of mixing, into an adhesive layer, an ultraviolet absorber based on benzophenone or benzotriazole, and others, to improve light resistance.
The inventors found that the method described in PTL 2 might not sufficiently improve light resistance. Furthermore, the inventors conducted research on the solution and accomplished the present invention.
An object of the present invention is to provide an optical sheet that has a good color correction function and can withstand long-term use.

[Solution to Problem]

For solving the above-described problem, an optical sheet according to a first aspect of the present invention includes:

a first adhesive layer containing an adhesive and a colorant, the first adhesive layer having a first surface and a second surface opposite the first surface; and
an ultraviolet shielding layer arranged to face the first surface of the first adhesive layer, wherein
the colorant contains at least one of

a first coloring material having a maximum absorption wavelength in a range of 470 to 530 nm and an absorption spectral half width of 15 to 45 nm,

a second coloring material having a maximum absorption wavelength in a range of 560 to 620 nm and an absorption spectral half width of 15 to 55 nm, and

a third coloring material in which a wavelength having the lowest transmittance in a wavelength range of 400 to 800 nm is in a range of 650 to 800 nm,

in the first adhesive layer, one of absorption wavelength bands of the colorant includes a maximum absorption wavelength at which a transmittance is 1% or more and less than 50%,

the ultraviolet shielding layer has an ultraviolet shielding rate according to JIS L 1925 of 85% or more, and

ΔE □ ab, which is a chromaticity difference between before and after a light resistance test of irradiating for 120 hours with a xenon lamp having an illuminance at wavelengths of 300 to 400 nm of 60 W/$cm^2$ at a temperature of 45°C and a humidity of 50% RH, satisfies Equation (1) below:

$$\Delta E \square ab \leq 5 \qquad \text{Equation (1).}$$

A display device according to a second aspect of the present invention includes a light source and the optical sheet according to the first aspect which is disposed with the first adhesive layer being arranged to face the light source.

[Advantageous Effects of the Invention]

According to the above-described aspects of the present invention, there can be provided: an optical sheet that has a good color correction function and can withstand long-term use; and a display device including the optical sheet.

[Brief Description of the Drawings]

Fig. 1 is a schematic cross-sectional view of an optical sheet 1 according to a first embodiment of the present invention.

Fig. 2 is a schematic cross-sectional view of an optical sheet 1A according to a second embodiment of the present invention.

Fig. 3 is a schematic cross-sectional view of an optical sheet 1B according to a third embodiment of the present invention.

Fig. 4 is a schematic cross-sectional view of an optical sheet 1C according to a fourth embodiment of the present invention.

Fig. 5 is a schematic cross-sectional view of an optical sheet 1D according to a fifth embodiment of the present invention.

Fig. 6 is a schematic cross-sectional view of an optical sheet 1E according to a sixth embodiment of the present invention.

Fig. 7 is a schematic cross-sectional view of an optical sheet 1F according to a seventh embodiment of the present invention.

Fig. 8 is a graph illustrating light transmission profiles of transparent substrates.

Fig. 9 shows a spectrum of a light source used in evaluation on transmission characteristics.

Fig. 10 shows spectra of light sources used in evaluation on color reproducibility.

[Description of the Embodiments]

Fig. 1 to Fig. 7 are schematic cross-sectional views of optical sheets 1 and 1A to 1F according to first to seventh embodiments of the present invention, respectively. In Fig. 1 to Fig. 7, the upper side corresponds to an observer side when a display image on a display device is observed.

<First embodiment>

Hereinafter, the first embodiment of the present invention will be described with reference to Fig. 1.

Fig. 1 is a schematic cross-sectional view of an optical sheet 1 according to the present embodiment. The optical sheet 1 includes a colored adhesive layer (first adhesive layer) 10 and an ultraviolet shielding layer 20 formed on the colored adhesive layer 10. The optical sheet 1 is configured as a sheet in which both surfaces in the thickness direction have adhesiveness. Both surfaces in the thickness direction of the optical sheet 1 are protected by separators S or the like before use. As the separators S, resin film, paper, or the like can be used. When the separator S is transparent,

the optical sheet 1 can be used without peeling the separator S.

In the present embodiment, a direction in which the colored adhesive layer 10 and the ultraviolet shielding layer 20 are laminated is referred to as a thickness direction, one side in the thickness direction (an observer side when a display image on a display device is observed) is referred to as an upper side, and a side opposite the upper side is referred to as a lower side.

The colored adhesive layer 10 contains an adhesive and a colorant. The adhesive is a resin that has adhesive properties. The resin component of the adhesive is not particularly limited, and examples thereof include silicone-based adhesives, acryl-based adhesives, and urethane-based adhesives. The colorant selectively absorbs the wavelength range of visible light. The colored adhesive layer 10 has a structure in which the colorant is contained in a base adhesive that has adhesive properties.

The colorant contains at least one from the group of three types of coloring materials including first to third coloring materials described below. The number of types of coloring materials to be contained is not limited to one, and two or more types of coloring materials may be contained.

The first coloring material has a maximum absorption wavelength in a range of 470 nm to 530 nm and an absorption spectral half width (full width at half maximum) of 15 nm to 45 nm.

The second coloring material has a maximum absorption wavelength in a range of 560 nm to 620 nm and an absorption spectral half width (full width at half maximum) of 15 nm to 55 nm.

In the third coloring material, a wavelength having the lowest transmittance in a wavelength range of 400 to 800 nm is in a range of 650 to 800 nm.

In the following description, the absorption spectral half width denotes the full width at half maximum.

The colored adhesive layer 10 has absorption in which the transmittance at the maximum absorption wavelength of one of absorption wavelength bands of the coloring materials is 1% or more and less than 50%.

When the coloring materials having the above-described absorption characteristics are used as the first to third coloring materials to be contained in the colored adhesive layer 10, the colored adhesive layer 10 can absorb, of visible light emitted by a display device, visible light in a wavelength region in which the light emission intensity is relatively low. For example, the colored adhesive layer 10 can absorb, of visible light in a wavelength range of 400 to 800 nm, visible light in a range of 470 nm to 530 nm, 560 nm to 620 nm, and 650 to 800 nm using the first, second, and third coloring materials, respectively. The wavelengths absorbed by the first, second, and third coloring materials are, for example, ranges overlapping wavelength regions in which the light emission intensity is relatively low, of visible light emitted by a display device in the spectroscopic spectrum during white display of an OLED display device illustrated in Fig. 9. The display device is not limited to the above-described OLED display device and may be other display devices.

As the first to third coloring materials, there can be used a coloring material that contains one or more compounds selected from the group consisting of a compound having any of a porphyrin structure, merocyanine structure, phthalocyanine structure, azo structure, cyanine structure, squarylium structure, coumarin structure, polyene structure, quinone structure, tetradiporphyrin structure, pyrromethene structure, and indigo structure, and a metal complex thereof. In particular, it is more preferable to use squarylium structure or a metal complex having, in the molecule, a porphyrin structure, pyrromethene structure, or phthalocyanine structure.

The colored adhesive layer 10 may contain at least one of a radical scavenger, a singlet oxygen quencher, and a peroxide decomposer.

The coloring material contained in the colored adhesive layer 10 is also degraded by light, heat, and other factors which are promoted under the influence of oxygen. When the radical scavenger is mixed in the colored adhesive layer 10, radicals produced during oxidative degradation of the colorant can be trapped to prevent degradation of the coloring material caused by autooxidation, which can further lengthen the period during which the color correction function is maintained.

Also, when the singlet oxygen quencher is present in the colored adhesive layer 10, it is possible to inactivate highly reactive singlet oxygen having the property of easily oxidatively degrading (fading) the colorant to suppress the oxidative degradation (color fading) of the colorant.

When the peroxide decomposer is present in the colored adhesive layer 10, the peroxide decomposer decomposes peroxides generated during oxidative degradation of the colorant, which can terminate the autooxidation cycle and suppress colorant degradation (color fading).

The radical scavenger and the singlet oxygen quencher may be used in combination. Furthermore, the peroxide decomposer may be combined therewith.

As the radical scavenger, a hindered amine photostabilizer can be used. A hindered amine photostabilizer having a molecular weight of 2,000 or more, with which high color fading suppression effects can be obtained, is particularly preferable. When the radical scavenger has a low molecular weight, it easily volatilizes with the result that the number of molecules remaining in the colored adhesive layer 10 is small, and thus it is sometimes difficult to obtain sufficient color fading suppression effects. Examples of a material suitably used as the radical scavenger include Chimassorb 2020FDL, Chimassorb 944FDL, and Tinuvin 622 manufactured by BASF, and LA-63P manufactured by ADEKA Corporation.

Examples of the singlet oxygen quencher include transition metal complexes, colorants, amines, phenols, and sulfides. Examples of particularly suitably used materials include transition metal complexes of dialkyl phosphates, dialkyl dithiocarbamates, or benzene dithiol or similar dithiols. As the central metal of these transition metal complexes, nickel, copper, or cobalt is suitably used.

The peroxide decomposer has the function of decomposing peroxides generated during oxidative degradation of the colorant, terminating the autooxidation cycle, and suppressing colorant degradation (color fading). As the peroxide decomposer, a phosphorus-based antioxidant and a sulfur-based antioxidant can be used.

Examples of the phosphorus-based antioxidant include 2,2'-methylenebis(4,6-di-t-butyl-1-phenyloxy)(2-ethylhexyloxy)phosphorus, 3,9-bis(2,6-di-tert-butyl-4-methylphenoxy)-2,4,8,10-tetraoxa-3,9-diphosphaspiro[5.5]undecane, and 6-[3-(3-t-butyl-4-hydroxy-5-methylphenyl)propoxy]-2,4,8,10-tetra-t-butyldibenz[d,F][1,3,2]dioxaphosphepine.

Examples of the sulfur-based antioxidant include 2,2-bis({[3-(dodecylthio)propionyl]oxy}methyl)-1,3-propanediyl-bis[3-(dodecylthio)propionate], 2-mercaptobenzimidazole, dilauryl-3,3'-thiodipropionate, dimyristyl-3,3'-thiodipropionate, distearyl-3,3'-thiodipropionate, pentaerythrityl-tetrakis(3-laurylthiopropionate), and 2-mercaptobenzothiazole.

The ultraviolet shielding layer 20 contains an ultraviolet absorber in order to suppress degradation of the colorant contained in the colored adhesive layer 10. Accordingly, the ultraviolet shielding layer 20 has an ultraviolet shielding rate of 85% or more. Here, the ultraviolet shielding rate is a value measured in accordance with JIS L 1925 and calculated according to the following equation:

$$\text{ultraviolet shielding rate (\%)} = 100 - \text{average transmittance (\%) of ultraviolet light at}$$

The absorption wavelength region in the ultraviolet region of the ultraviolet absorber contained in the ultraviolet shielding layer 20 is preferably in a range of 290 to 370 nm. Examples of such an ultraviolet absorber include benzophenone-based, benzotriazole-based, triazine-based, oxalic acid anilide-based, and cyanoacrylate-based compounds. The ultraviolet absorber is added for suppressing degradation of the colorant contained in the colored adhesive layer 10. Therefore, an ultraviolet absorber is used that has properties of absorbing light in a wavelength region that contributes to the degradation of the colorant contained in the colored adhesive layer 10, of the ultraviolet region.

The ultraviolet shielding layer 20 may further contain a resin that exerts adhesiveness. Hereinafter, when the ultraviolet shielding layer 20 contains a resin that exerts adhesiveness, it is also referred to as an "ultraviolet absorption adhesive layer 20" or a "second adhesive layer 20". In the ultraviolet absorption adhesive layer 20, the resin component exerting adhesiveness is not particularly limited, and resins similar to in the colored adhesive layer 10 can be used.

The optical sheet 1 can be manufactured by forming one of the colored adhesive layer 10 and the ultraviolet shielding layer (ultraviolet absorption adhesive layer) 20 on a base film formed with resin or the like, forming the other thereon, and peeling the base film. The base film may not be peeled and used as the separator S.

The colored adhesive layer 10 and the ultraviolet shielding layer (ultraviolet absorption adhesive layer) 20 can be formed by, for example, coating with a coating liquid that contains constituent materials of each layer and drying the coat.

By peeling the separator S, the colored adhesive layer 10 or the ultraviolet shielding layer (ultraviolet absorption adhesive layer) 20 can be bonded and attached to various objects to impart a color correcting ability thereto.

Examples of objects to have the optical sheet 1 attached include various optical function films such as antireflection films and anti-glare films and display devices such as displays. The optical sheet 1 is attached in such a manner that externally incident light containing ultraviolet light passes through the ultraviolet shielding layer (ultraviolet absorption adhesive layer) 20 and then enters the colored adhesive layer 10.

When light emitted from a light source (light emitted from the display device side) passes through the colored adhesive layer 10, a wavelength component at and around the maximum absorption wavelength of the contained coloring material is absorbed. This can improve the color purity of the display device. Furthermore, unlike in a color filter, the concentration of the coloring material does not need to be increased very much, and thus color purity can be improved without excessively lowering the luminance of the display device.

The coloring material contained in the colored adhesive layer 10 is excellent in color correction function but sometimes has insufficient resistance to light, especially to ultraviolet light. Therefore, degradation proceeds with time in response to irradiation with ultraviolet light, with the result that light at and around the maximum absorption wavelength cannot be absorbed.

In the optical sheet 1 of the present embodiment, the ultraviolet shielding layer (ultraviolet absorption adhesive layer) 20 has a high ultraviolet shielding rate. Therefore, when the optical sheet 1 is attached in the above-described

manner, a major portion of ultraviolet light contained in external light does not pass through the ultraviolet shielding layer (ultraviolet absorption adhesive layer) 20 and fails to reach the colored adhesive layer 10. Accordingly, ΔE □ ab, which is a chromaticity difference between before and after a light resistance test (irradiation for 120 hours under the conditions of a xenon lamp illuminance of 60 W/$cm^2$ (300 to 400 nm), a temperature of 45°C, and a humidity of 50% RH), can satisfy Equation (1) below:

$$\Delta E \,\square\, ab \leq 5 \qquad \text{Equation (1).}$$

In brief, degradation of the coloring material contained in the colored adhesive layer 10 can be prevented, and the color correction function can be maintained for a long time. It is noted that ΔE □ ab of Equation (1) is a chromaticity difference standardized by the CIE (Commission International del'Eclairage).

<Second embodiment>

The second embodiment of the present invention will be described with reference to Fig. 2. In the following description, components that are common to those described above are denoted by the same reference signs, and duplicated description thereof will be omitted.
Fig. 2 is a schematic cross-sectional view illustrating a layer structure of an optical sheet 1A of the present embodiment. The optical sheet 1A includes, in place of the ultraviolet absorption adhesive layer 20, a transparent substrate 30. Since the transparent substrate 30 does not have adhesiveness, the separator S is disposed only to the colored adhesive layer 10 side.
The transparent substrate 30 has an ultraviolet shielding rate of 85% or more and functions as an ultraviolet shielding layer. The definition of the ultraviolet shielding rate is the same as that explained regarding the ultraviolet shielding layer (ultraviolet absorption adhesive layer) 20.
Examples of usable materials of the transparent substrate 30 include polyolefins such as polyethylene and polypropylene, polyesters such as polyethylene terephthalate, polybutylene terephthalate, and polyethylene naphthalate, polyacrylates such as polymethyl methacrylate, polyamides such as nylon 6 and nylon 66, transparent resins such as polyimide, polyarylate, polycarbonate, triacetyl cellulose, polyacrylates, polyvinyl alcohols, polyvinyl chloride, cycloolefin copolymers, norbornene-containing resins, polyether sulfones, and polysulfone, and inorganic glasses. Among these, a film formed of polyethylene terephthalate (PET), a film formed of triacetyl cellulose (TAC), a film formed of polymethyl methacrylate (PMMA), and a film formed of polyester can be suitably used. The thickness of the transparent substrate 30 is not particularly limited but preferably 10 to 100 μm.
Fig. 8 illustrates light transmission profiles of transparent substrates formed of these materials.
In Fig. 8, the ultraviolet shielding rates of the transparent substrates are as described below, and any of them can be suitably used as the transparent substrate 30.

TAC: 91.7%
PMMA: 90.2%
PET: 88.1%

The ultraviolet shielding rate of the transparent substrate is not particularly limited, and may depend on the absorption characteristics of resin, or the ultraviolet absorber described as an example for the ultraviolet shielding layer (ultraviolet absorption adhesive layer) 20 may be used.
In the optical sheet 1A according to the present embodiment, the transparent substrate 30 suppresses deterioration of the coloring material contained in the colored adhesive layer 10 caused by ultraviolet light. As a result, the same effects as those of the optical sheet 1 according to the first embodiment can be exerted.
In the optical sheet 1A, a transparent adhesive layer may be disposed on a side of the transparent substrate 30 where the colored adhesive layer 10 is not disposed (on the upper side of the transparent substrate 30). This allows an object to be bonded to a side where the colored adhesive layer 10 is not disposed and thus enhances versatility.

<Third embodiment>

The third embodiment of the present invention will be described with reference to Fig. 3.
Fig. 3 is a schematic cross-sectional view illustrating a layer structure of an optical sheet 1B of the present embodiment. The optical sheet 1B includes, in the structure of the optical sheet 1, a transparent substrate 30 on a surface of the ultraviolet shielding layer (ultraviolet absorption adhesive layer) 20 opposite the surface on which the colored adhesive layer 10 is disposed (on the upper surface of the ultraviolet shielding layer 20). The transparent substrate 30

may contain the ultraviolet absorber described as an example for the ultraviolet shielding layer 20.

The separator S is disposed only on a surface of the colored adhesive layer 10 opposite the surface on which the ultraviolet shielding layer (ultraviolet absorption adhesive layer) 20 is disposed (on the lower surface of the colored adhesive layer 10).

In the optical sheet 1B according to the present embodiment, the transparent substrate 30 and the ultraviolet shielding layer (ultraviolet absorption adhesive layer) 20 suppress deterioration of the coloring material contained in the colored adhesive layer 10 caused by ultraviolet light. As a result, effects that are the same as or more than those of the optical sheet 1 according to the first embodiment and/or the optical sheet 1A according to the second embodiment are exerted.

In the optical sheet 1B, a transparent adhesive layer may be disposed on a side of the transparent substrate 30 where the colored adhesive layer 10 is not disposed (on the upper side of the transparent substrate 30). This allows an object to be bonded to a side where the colored adhesive layer 10 is not disposed (to the upper side of the transparent substrate 30) and thus enhances versatility.

<Fourth embodiment>

The fourth embodiment of the present invention will be described with reference to Fig. 4.

Fig. 4 is a schematic cross-sectional view illustrating a layer structure of an optical sheet 1C of the present embodiment. The optical sheet 1C includes an oxygen barrier layer 40 on a surface of the transparent substrate 30 opposite the surface on which the colored adhesive layer 10 is disposed (on the upper surface of the transparent substrate 30). When the transparent substrate 30 has the absorption characteristics of resin and contains the ultraviolet absorber described as an example for the ultraviolet absorption adhesive layer 20 to have ultraviolet shielding properties, the transparent substrate 30 may serve as an ultraviolet shielding layer as in an example illustrated in Fig. 4.

The oxygen barrier layer 40 is an optically transmissive, transparent layer and has an oxygen permeability of 10 cc/($m^2$·day·atm) or less, more preferably 5 cc/($m^2$·day·atm) or less, and further preferably 1 cc/($m^2$·day·atm) or less. A material for forming the oxygen barrier layer 40 preferably contains polyvinyl alcohol (PVA), ethylene-vinyl alcohol copolymers (EVOH), vinylidene chloride, siloxane resin, and others, and Maxive (registered trademark) manufactured by Mitsubishi Gas Chemical Company, Inc., EVAL manufactured by Kuraray Co., Ltd., Saran Latex and Saran Resin manufactured by Asahi Kasei Corp., and others can be used. The thickness of the oxygen barrier layer 40 is not particularly limited and has only to be a thickness that enables desired oxygen barrier properties to be obtained.

Also, inorganic particles (particles including an inorganic compound) may be dispersed in the oxygen barrier layer 40. The inorganic particles can further lower the oxygen permeability and can further suppress the oxidative degradation (color fading) of the colored adhesive layer 10. The size and content of the inorganic particles are not particularly limited and have only to be appropriately set depending on, for example, the thickness of the oxygen barrier layer 40. The size (maximum length) of the inorganic particles dispersed in the oxygen barrier layer 40 is preferably less than the thickness of the oxygen barrier layer 40 and advantageously as small as possible. The size of the inorganic particles dispersed in the oxygen barrier layer 40 may be either uniform or non-uniform. Specific examples of the inorganic particles dispersed in the oxygen barrier layer 40 include silica particles, alumina particles, silver particles, copper particles, titanium particles, zirconia particles, and tin particles.

In the optical sheet 1C according to the present embodiment, the oxygen barrier layer 40 can suppress degradation of the coloring material contained in the colored adhesive layer 10 caused by light, heat, and other factors which are promoted under the influence of oxygen in external air, so that the color correction function can be maintained for a further long time.

In the present embodiment, the number of oxygen barrier layers 40 and the position thereof can be appropriately set. For example, the oxygen barrier layer 40 has only to be laminated on the viewer side as a layer above the colored adhesive layer 10. Also, in the optical sheets 1A and 1C according to the second and fourth embodiments, the oxygen barrier layer 40 may be disposed between the colored adhesive layer 10 and the transparent substrate 30. Also, in the optical sheet 1B according to the third embodiment, the oxygen barrier layer 40 may be disposed between the colored adhesive layer 10 and the ultraviolet absorption adhesive layer 20 or between the ultraviolet absorption adhesive layer 20 and the transparent substrate 30. When the oxygen barrier layer 40 is provided, oxygen contained in external air does not reach the colored adhesive layer 10 as long as it does not pass through the oxygen barrier layer 40, similarly to in the fourth embodiment. This can suppress degradation of the coloring material caused by oxygen in the external air, so that the color correction function can be maintained for a further long time.

In the optical sheet 1C, a transparent adhesive layer may be disposed on the oxygen barrier layer 40. This allows an object to be bonded to the oxygen barrier layer 40 side and thus enhances versatility.

<Fifth embodiment>

The fifth embodiment of the present invention will be described with reference to Fig. 5.

Fig. 5 is a schematic cross-sectional view illustrating a layer structure of an optical sheet 1D of the present embodiment. The optical sheet 1D includes a transparent substrate 30, a colored adhesive layer 10 arranged to face a first surface of the transparent substrate 30 (the lower surface of the transparent substrate 30), and an optical function layer 50 formed on a second surface that is opposite to the first surface on the transparent substrate 30 (on the upper side of the transparent substrate 30). The optical sheet 1D includes, as the optical function layer 50, a hardcoat layer 51 and a low refractive index layer 52 formed on the hardcoat layer 51.

The hardness of the hardcoat layer 51 is preferably H or above in pencil hardness at a surface load of 500 g.

The hardcoat layer 51 is a hard resin layer and enhances the scratch resistance of the optical sheet 1D. Also, the hardcoat layer 51 may have a refractive index higher than that of the low refractive index layer 52. A resin constituting the hardcoat layer 51 is a resin curable by polymerization with the irradiation of active energy rays such as ultraviolet light and electron beams. Examples of such a resin to be used include monofunctional, bifunctional, or trifunctional or higher (meth)acrylate monomers. As described herein, "(meth)acrylate " is a generic name for both acrylate and methacrylate, and "(meth)acryloyl" is a generic name for both acryloyl and methacryloyl.

Examples of the monofunctional (meth)acrylate compound include 2-hydroxyethyl (meth)acrylate, 2-hydroxypropyl (meth)acrylate, 2-hydroxybutyl (meth)acrylate, n-butyl (meth)acrylate, isobutyl (meth)acrylate, t-butyl (meth)acrylate, glycidyl (meth)acrylate, acryloylmorpholine, N-vinylpyrrolidone, tetrahydrofurfuryl acrylate, cyclohexyl (meth)acrylate, 2-ethylhexyl (meth)acrylate, isobornyl (meth)acrylate, isodecyl (meth)acrylate, lauryl (meth)acrylate, tridecyl (meth)acrylate, cetyl (meth)acrylate, stearyl (meth)acrylate, benzyl (meth)acrylate, 2-ethoxyethyl (meth)acrylate, 3-methoxybutyl (meth)acrylate, ethyl carbitol (meth)acrylate, phosphate (meth)acrylate, ethylene-oxide-modified phosphate (meth)acrylate, phenoxy (meth)acrylate, ethylene-oxide-modified phenoxy (meth)acrylate, propylene-oxide-modified phenoxy (meth)acrylate, nonyl phenol (meth)acrylate, ethylene-oxide-modified nonyl phenol (meth)acrylate, propylene-oxide-modified nonyl phenol (meth)acrylate, methoxy diethylene glycol (meth)acrylate, methoxy polythylene glycol (meth)acrylate, methoxy propylene glycol (meth)acrylate, 2-(meth)acryloyl oxyethyl-2-hydroxy propyl phthalate, 2-hydroxy-3-phenoxy propyl (meth)acrylate, 2-(meth)acryloyl oxyethyl hydrogen phthalate, 2-(meth)acryloyl oxypropyl hydrogen phthalate, 2-(meth)acryloyl oxypropyl hexahydro hydrogen phthalate, 2-(meth)acryloyl oxypropyl tetrahydro hydrogen phthalate, dimethylaminoethyl (meth)acrylate, trifluoroethyl (meth)acrylate, tetrafluoropropyl (meth)acrylate, hexafluoropropyl (meth)acrylate, octafluoropropyl (meth)acrylate, and adamantine derivatives of mono(meth)acrylates, such as adamantyl acrylate having monovalent mono(meth)acrylate derived from 2-adamantane and an adamantine diol.

Examples of the difunctional (meth)acrylate compound include di(meth)acrylates such as ethylene glycol di(meth)acrylate, diethylene glycol di(meth)acrylate, butanediol di(meth)acrylate, hexanediol di(meth)acrylate, nonanediol di(meth)acrylate, ethoxylated hexanediol di(meth)acrylate, propoxylated hexanediol di(meth)acrylate, diethylene glycol di(meth)acrylate, polyethylene glycol di(meth)acrylate, tripropylene glycol di(meth)acrylate, polypropylene glycol di(meth)acrylate, neopentyl glycol di(meth)acrylate, ethoxylated neopentyl glycol di(meth)acrylate, tripropylene glycol di(meth)acrylate, and hydroxy pivalic acid neopentyl glycol di(meth)acrylate.

Examples of the trifunctional or higher (meth)acrylate compound include tri(meth)acrylates such as trimethylolpropane tri(meth)acrylate, ethoxylated trimethylolpropane tri(meth)acrylate, propoxylated trimethylolpropane tri(meth)acrylate, tris-2-hydroxyethyl isocyanurate tri(meth)acrylate, and glycerol tri(meth)acrylate, trifunctional (meth)acrylate compounds such as pentaerythritol tri(meth)acrylate, dipentaerythritol tri(meth)acrylate, and ditrimethylolpropane tri(meth)acrylate, trifunctional or higher polyfunctional (meth)acrylate compounds such as pentaerythritol tetra(meth)acrylate, ditrimethylolpropane tetra(meth)acrylate, dipentaerythritol tetra(meth)acrylate, dipentaerythritol penta(meth)acrylate, ditrimethylolpropane penta(meth)acrylate, dipentaerythritol hexa(meth)acrylate, and ditrimethylolpropane hexa(meth)acrylate, and polyfunctional (meth)acrylate compounds in which a part of each of these (meth)acrylates is substituted with an alkyl group or ε-caprolactone.

As the active energy ray-curing resin, urethane (meth)acrylate can also be used. An example of the urethane (meth)acrylate is one obtained by allowing a product obtained by allowing polyester polyol to react with an isocyanate monomer or prepolymer to react with a (meth)acrylate monomer having a hydroxyl group.

Examples of the urethane (meth)acrylate include a pentaerythritol triacrylate hexamethylene diisocyanate urethane prepolymer, a dipentaerythritol pentaacrylate hexamethylene diisocyanate urethane prepolymer, a pentaerythritol triacrylate toluene diisocyanate urethane prepolymer, a dipentaerythritol pentaacrylate toluene diisocyanate urethane prepolymer, a pentaerythritol triacrylate isophorone diisocyanate urethane prepolymer, and a dipentaerythritol pentaacrylate isophorone diisocyanate urethane prepolymer.

The above-described resins may be used singly or in combination of two or more. Also, the above-described resins may be a monomer in a composition for forming a hardcoat layer or a partially polymerized oligomer.

The hardcoat layer 51 may contain the previously described ultraviolet absorber, in order to suppress degradation of the colorant contained in the colored adhesive layer 10. However, when the amount of ultraviolet light absorbed

by the ultraviolet absorber is excessively large during curing of the composition that contains the ultraviolet absorber, curing of the composition becomes insufficient, and the obtained optical sheet sometimes has insufficient surface hardness. Therefore, it is preferable to use an ultraviolet absorber in which the absorption wavelength region in the ultraviolet region is in a range that is different from the absorption wavelength region in the ultraviolet region of the photoinitiator to suppress inhibition of curing when an ultraviolet absorber is present, and an acylphosphine oxide-based photoinitiator can be suitably used. Examples of the acylphosphine oxide-based photoinitiator include diphenyl(2,4,6-trimethylbenzoyl)phosphine oxide and phenylbis(2,4,6-trimethylbenzoyl)phosphine oxide.

Also, a composition for forming the hardcoat layer 51 may contain metal oxide fine particles for purposes of adjusting the refractive index and imparting hardness. Examples of the metal oxide fine particles include zirconium oxide, titanium oxide, niobium oxide, antimony trioxide, antimony pentoxide, tin oxide, indium oxide, indium tin oxide, and zinc oxide.

The hardcoat layer 51 can be simply formed when formed with an energy ray-curing type compound such as an ultraviolet light-curing resin. In this case, the hardcoat layer 51 can be formed by coating with a coating liquid that contains an energy ray-curing type compound, a photoinitiator, and an ultraviolet absorber and irradiating the coat with the corresponding energy ray.

When the optical sheet 1D is applied to a display device, the low refractive index layer 52 is disposed on a side that is closest to a user (viewer) who views a display. The low refractive index layer 52 prevents the strong reflection of external light and improves the visibility of a display device.

The low refractive index layer 52 may be a layer that includes an inorganic material or an inorganic compound. Examples of the inorganic material and the inorganic compound include fine particles of LiF, MgF, 3NaF·AlF, AlF, $Na3AlF_6$, and others as well as silica fine particles. Also, when silica fine particles have voids inside the particles, such as porous silica fine particles and hollow silica fine particles, the refractive index of the low refractive index layer can be effectively lowered. Also, the composition for forming the low refractive index layer 52 may be appropriately formulated with the photoinitiator, the solvent, and other additives described for the hardcoat layer 51.

The refractive index of the low refractive index layer 52 has only to be lower than the refractive index of the transparent substrate 30 and preferably 1.55 or less. Also, the film thickness of the low refractive index layer 52 is not particularly limited but preferably 40 nm to 1 μm.

The low refractive index layer 52 may contain any of silicon oxide, fluorine-containing silane compounds, fluoroalkyl silazane, fluoroalkyl silane, fluorine-containing silicon-based compounds, and perfluoropolyether group-containing silane coupling agents. Since these materials can impart water and/or oil repellency to the low refractive index layer 52, anti-fouling properties can be enhanced.

The low refractive index layer 52 may be formed by, for example, vapor deposition or sputtering. Also, it may be formed by coating with a coating liquid that contains constituent materials of the low refractive index layer 52 and drying the coat.

The optical sheet 1D according to the present embodiment can exert the same effects as those of the above-described embodiments and the optical function based on the optical function layer 50.

<Sixth embodiment>

The sixth embodiment of the present invention will be described with reference to Fig. 6.

Fig. 6 is a schematic cross-sectional view illustrating a layer structure of an optical sheet 1E of the present embodiment. The optical sheet 1E includes a colored adhesive layer 10, an ultraviolet shielding layer 20, a transparent substrate 30, and an optical function layer 50. The ultraviolet shielding layer 20 is formed to face a first surface of the transparent substrate 30 (the lower surface of the transparent substrate 30). The optical function layer 50 is formed on a second surface opposite the first surface on the transparent substrate 30 (on the upper surface side of the transparent substrate 30). The optical sheet 1E includes an anti-glare layer 53 as the optical function layer 50.

Also, when the transparent substrate 30 has ultraviolet shielding properties by having the absorption characteristics of resin and containing the ultraviolet absorber described as an example for the ultraviolet absorption adhesive layer 20, the optical sheet 1E has only to include the colored adhesive layer 10, the transparent substrate 30, and the optical function layer 50.

The anti-glare layer 53 is a layer that has microscopic asperities on the surface and scatters external light by the microscopic asperities to reduce reflected glare of external light. The anti-glare layer 53 can be formed by coating with a composition for forming an anti-glare layer that contains an active energy ray-curing resin and, as necessary, organic fine particles and/or inorganic fine particles. Examples of the active energy ray-curing resin used in the composition for forming an anti-glare layer include the resins described with regard to the hardcoat layer 51. The film thickness of the anti-glare layer 53 is not particularly limited but preferably 1 to 10 μm.

The organic fine particles used in the composition for forming an anti-glare layer are a material that mainly forms microscopic asperities on the surface of the anti-glare layer 53 to impart the function of scattering external light.

Examples of usable organic fine particles include resin particles constituted by a translucent resin material such as acrylic resin, polystyrene resin, styrene-(meth)acrylic acid ester copolymers, polyethylene resin, epoxy resin, silicone resin, polyvinylidene fluoride, and polyethylene fluoride-based resin. For adjusting the refractive index and the dispersibility of resin particles, two or more types of resin particles having different material properties (refractive indices) may be mixed and used.

The inorganic fine particles used in the composition for forming an anti-glare layer are a material for mainly adjusting the sedimentation and aggregation of organic fine particles in the anti-glare layer 53. Examples of usable inorganic fine particles include silica fine particles, metal oxide fine particles, and various mineral fine particles. Examples of usable silica fine particles include colloidal silica and silica fine particles surface-modified with a reactive functional group such as a (meth)acryloyl group. Examples of usable metal oxide fine particles include alumina, zinc oxide, tin oxide, antimony oxide, indium oxide, titania, and zirconia. Examples of usable mineral fine particles include mica, synthetic mica, vermiculite, montmorillonite, iron montmorillonite, bentonite, beidellite, saponite, hectorite, stevensite, nontronite, magadiite, ilerite, kanemite, layered titanic acid, smectite, and synthetic smectite. The mineral fine particles to be used may be either a natural product or a synthetic product (including a substituted body and a derivative) and may be a mixture of both. Among the mineral fine particles, a layered organic clay is more preferable. Layered organic clay refers to swellable clay including organic onium ions introduced in the interlayer. The organic onium ion may be any one that can convert the swellable clay into an organic form by utilizing the cation exchangeability of the swellable clay. When layered organic clay mineral is used as mineral fine particles, the above-mentioned synthetic smectite can be suitably used. The synthetic smectite has the function of increasing the viscosity of the coating liquid for forming an anti-glare layer, suppressing the sedimentation of resin particles and inorganic fine particles, and adjusting the concavo-convex shape of the surface of the optical function layer.

The composition for forming an anti-glare layer may contain any of silicon oxide, fluorine-containing silane compounds, fluoroalkyl silazane, fluoroalkyl silane, fluorine-containing silicon-based compounds, and perfluoropolyether group-containing silane coupling agents. Since these materials can impart water and/or oil repellency to the anti-glare layer 53, anti-fouling properties can be enhanced.

The anti-glare layer 53 may be formed as a layer in which a layer having a relatively high refractive index and a layer having a relatively low refractive index are laminated sequentially from the colored adhesive layer 10 side (from the lower side), by allowing the materials to be unevenly distributed. The anti-glare layer 53 in which the materials are unevenly distributed can be formed by, for example, coating with a composition including a high refractive index material and a low refractive index material that contains surface-treated silica fine particles or hollow silica fine particles, and phase-separating the coat by taking advantage of a difference in surface free energy between both materials. When the anti-glare layer 53 is constituted by the two phase-separated layers, it is preferable that the layer having a relatively high refractive index on the transparent substrate 30 side has a refractive index of 1.50 to 2.40, and the layer having a relatively low refractive index on the surface side of the optical sheet 1E has a refractive index of 1.20 to 1.55. The anti-glare layer 53 can be formed by, for example, coating with a coating liquid that contains constituent materials of each layer and drying the coat.

The optical sheet 1E according to the present embodiment can exert the same effects as those of the above-described embodiments and the optical function based on the optical function layer 50.

<Seventh embodiment>

The seventh embodiment of the present invention will be described with reference to Fig. 7.

Fig. 7 is a schematic cross-sectional view illustrating a layer structure of an optical sheet 1F of the present embodiment. The optical sheet 1F includes a colored adhesive layer 10, an ultraviolet shielding layer 20, a transparent substrate 30, and an optical function layer 50. The ultraviolet shielding layer 20 is formed to face a first surface of the transparent substrate 30 (the lower surface of the transparent substrate 30). The optical function layer 50 is formed on a second surface opposite the first surface on the transparent substrate 30 (on the upper surface side of the transparent substrate 30). The optical sheet 1E includes, as the optical function layer 50, an anti-glare layer 53 and a low refractive index layer 52 formed on the anti-glare layer 53.

Also, when the transparent substrate 30 has the absorption characteristics of resin and contains the ultraviolet absorber described as an example for the ultraviolet absorption adhesive layer 20 to have ultraviolet shielding properties, the optical sheet 1F has only to include the colored adhesive layer 10, the transparent substrate 30, and the optical function layer 50.

The optical sheet 1F can be manufactured by laminating the ultraviolet shielding layer 20 and the colored adhesive layer 10, or the colored adhesive layer 10, to the first surface side of the transparent substrate 30 (to the lower surface side of the transparent substrate 30), and sequentially forming the anti-glare layer 53 and the low refractive index layer 52 on the second surface opposite the first surface on the transparent substrate 30 (on the upper surface side of the transparent substrate 30).

In the optical sheet 1F according to the present embodiment, the anti-glare layer 53 and the low refractive index layer 52 can prevent reflected glare and strong reflection of external light and improve the visibility of a display device.

In the present embodiment, the optical function layer 50 is not limited to the above-described structures, and the exerted optical function also changes by changing the structure.

For example, an anti-reflection layer including a combination of a low refractive index layer and a high refractive index layer is also an example of the optical function layer 50 in the present invention. The low refractive index layer may be the same structure as the low refractive index layer 52 described in the fifth embodiment. The high refractive index layer may be disposed on a surface below the low refractive index layer and have a refractive index that is higher than that of the low refractive index layer. According to the anti-reflection layer including a combination of a low refractive index layer and a high refractive index layer, strong reflection of external light can be prevented, and visibility of a display device can be improved.

Also, an anti-reflection layer including a high refractive index layer and an anti-glare layer is an example of the optical function layer 50 in the present invention. The anti-glare layer may be the same structure as the anti-glare layer 53 described in the sixth embodiment. The high refractive index layer may be disposed on a surface below the anti-glare layer 53 and have a refractive index higher than that of the anti-glare layer 53. Also, the anti-reflection layer including a high refractive index layer and an anti-glare layer may further include the low refractive index layer 52. These structures can further improve the visibility of a display device.

Also, in the present embodiment, an ultraviolet shielding function (ultraviolet absorption properties) may be imparted to the optical function layer 50 to allow the optical function layer 50 to function as an ultraviolet shielding layer. In this case, the transparent substrate 30 may not have an ultraviolet shielding function. When the optical function layer 50 has an ultraviolet shielding function, an ultraviolet absorber has only to be added to the hardcoat layer 51 and the anti-glare layer 53. When an ultraviolet absorber is contained in the hardcoat layer 51 including an ultraviolet light-curing resin, it is preferable that the absorption wavelength region in the ultraviolet region of the photoinitiator is different from the absorption wavelength region in the ultraviolet region of the ultraviolet absorber.

Examples

The optical sheet according to the present invention will be further described using examples and comparative examples. The present invention is not limited in any way by the specific contents of the following examples.

(Examples 1 to 17 and Comparative Examples 1 to 12)

In the following examples and comparative examples, optical sheets 1 to 22 having layer structures illustrated in Tables 1 to 3 were prepared, and properties of the prepared optical sheets were evaluated. Also, optical properties of OLED display devices 1 to 7 which include the optical sheets 6, 11, 12, and 19 to 22 were confirmed by simulation.

[Table 1]

| | | Example 1 | Example 2 | Example 3 | Example 4 | Example 5 | Example 6 | Example 7 | Example 8 | Example 9 |
|---|---|---|---|---|---|---|---|---|---|---|
| Optical sheet | | Optical sheet 1 | Optical sheet 2 | Optical sheet 3 | Optical sheet 4 | Optical sheet 5 | Optical sheet 6 | Optical sheet 7 | Optical sheet 8 | Optical sheet 9 |
| | Functional layer 1 | Low RI layer | Low RI layer | Low RI layer | Low RI layer | Low RI layer | Low RI layer | Low RI layer | Low RI layer | Low RI layer |
| | Functional layer 2 | Hardcoat layer 1 | Hardcoat layer 2 | Hardcoat layer 1 | Hardcoat layer 1 | Hardcoat layer 1 | Hardcoat layer 1 | Hardcoat layer 1 | Hardcoat layer 1 | Hardcoat layer 1 |
| | Functional layer 3 | - | - | - | - | - | - | Oxygen barrier layer | - | - |
| | Substrate | PMMA2 | PMMA2 | TAC | TAC | TAC | TAC | TAC | PMMA1 | PET1 |
| | 2nd adhesive layer | Adhesive layer 8 | | | | | | | | |
| | 1st adhesive layer | Adhesive layer 1 | Adhesive layer 1 | Adhesive layer 1 | Adhesive layer 3 | Adhesive layer 4 | Adhesive layer 5 | Adhesive layer 1 | Adhesive layer 5 | Adhesive layer 5 |
| Adherend | | Glass | Glass | Glass | Glass | Glass | Glass | Glass | Glass | Glass |

[Table 2]

| | | Example 10 | Example 11 | Example 12 | Example 13 | Example 14 | Comparative Example 1 | Comparative Example 2 | Comparative Example 3 | Comparative Example 4 |
|---|---|---|---|---|---|---|---|---|---|---|
| Optical sheet | | Optical sheet 10 | Optical sheet 11 | Optical sheet 12 | Optical sheet 13 | Optical sheet 14 | Optical sheet 15 | Optical sheet 16 | Optical sheet 17 | Optical sheet 18 |
| | Functional layer 1 | Low RI layer | Low RI layer | Low RI layer | | | Low RI layer | Low RI layer | Low RI layer | Low RI layer |
| | Functional layer 2 | Hardcoat layer 1 | Hardcoat layer 1 | Hardcoat layer 1 | Anti-glare layer 1 | Hardcoat layer 1 | Hardcoat layer 1 | Hardcoat layer 1 | Hardcoat layer 1 | Hardcoat layer 1 |
| | Functional layer 3 | | | | | | | | | |
| | Substrate | PET2 | TAC | TAC | TAC | TAC | PMMA2 | PMMA2 | PMMA2 | PMMA2 |
| | 2nd adhesive layer | - | - | - | - | - | - | - | - | - |
| | 1st adhesive layer | Adhesive layer 5 | Adhesive layer 6 | Adhesive layer 7 | Adhesive layer 1 | Adhesive layer 1 | Adhesive layer 1 | Adhesive layer 2 | Adhesive layer 6 | Adhesive layer 7 |
| Adherend | | Glass | Glass | Glass | Glass | Glass | Glass | Glass | Glass | Glass |

[Table 3]

| | | Comparative Example 5 | Comparative Example 6 | Comparative Example 7 | Comparative Example 8 |
|---|---|---|---|---|---|
| Optical sheet | | Optical sheet 19 | Optical sheet 20 | Optical sheet 21 | Optical sheet 22 |
| | Functional layer 1 | Low RI layer | Low RI layer | Low RI layer | Low RI layer |
| | Functional layer 2 | Hardcoat layer 1 | Hardcoat layer 1 | Hardcoat layer 1 | Hardcoat layer 1 |
| | Functional layer 3 | | | | |
| | Substrate | TAC | TAC | TAC | TAC |
| | 2nd adhesive layer | | | | |
| | 1st adhesive layer | Adhesive layer 8 | Adhesive layer 9 | Adhesive layer 10 | Adhesive layer 11 |
| Adherend | | Glass | Glass | Glass | Glass |

<Preparation of optical sheet>

Hereinafter, a method of forming each layer will be described.

(Substrate)

The following transparent substrates were used.

· TAC: triacetyl cellulose film (TG60UL manufactured by Fujifilm Corporation, substrate thickness: 60 μm, ultraviolet shielding rate: 92.9%)

· PMMA1: polymethyl methacrylate film (W001U80 manufactured by Sumitomo Chemical Co., Ltd., substrate thickness: 80 μm, ultraviolet shielding rate: 93.4%)

· PMMA2: polymethyl methacrylate film (W002N80 manufactured by Sumitomo Chemical Co., Ltd., substrate thickness: 80 μm, ultraviolet shielding rate: 13.9%)

· PET1: polyethylene terephthalate film (SRF manufactured by Toyobo Co., Ltd., substrate thickness: 80 μm, ultraviolet shielding rate: 88.3%)

· PET2: polyethylene terephthalate film (TOR 20 manufactured by SKC Co., substrate thickness: 40 μm, ultraviolet shielding rate: 88.6%)

(Preparation of optical function layer)

[Formation of oxygen barrier layer]

An 80% aqueous solution of PVA 117 (manufactured by Kuraray Co., Ltd.) was applied on the transparent substrate of Example 7 illustrated in Table 1 and dried to form an oxygen barrier layer having an oxygen permeability of 1 cc/($m^2$·day·atm).

[Formation of hardcoat layer]

(Composition for forming hardcoat layer)

The compositions illustrated in Table 4 were prepared with the following materials of a composition for forming a hardcoat layer.

· Active energy ray-curing resin:

UA-306H (manufactured by Kyoeisha Chemical Co., Ltd., pentaerythritol triacrylate hexamethylene diisocyanate urethane prepolymer)
DPHA (dipentaerythritol hexaacrylate)
PETA (pentaerythritol triacrylate)

· Initiator:
Omnirad TPO (manufactured by IGM Resins B. V)
· Ultraviolet absorber:

Tinuvin 479 (manufactured by BASF Japan Ltd., maximum absorption wavelength: 322 nm)
LA-36 (manufactured by ADEKA Corporation, maximum absorption wavelength: 310 nm, 350 nm)

· Solvent:
MEK (methyl ethyl ketone)
Methyl acetate

[Table 4]

| | | Hardcoat layer 1 | Hardcoat layer 2 |
|---|---|---|---|
| Active energy ray-curing resin | Type | UA-306H/DPHA/PETA | UA-3 06H/DPHA/PETA |
| | Ratio | 70/20/10 | 70/20/10 |
| | Amount | 45.4% | 42.2% |
| Photoinitiator | Type | Omnirad TPO | Omnirad TPO |
| | Amount | 4.6% | 4.6% |
| Ultraviolet absorber | Type | - | Tinuvin 479/LA36 |
| | Ratio | - | 40/60 |
| | Amount | - | 3% |
| Solvent | Type | MEK/methyl acetate | MEK/methyl acetate |
| | Ratio | 50/50 | 50/50 |
| | Amount | 50% | 50% |

The transparent substrate or the oxygen barrier layer illustrated in Table 1 to Table 3 was coated with the composition for forming a hardcoat layer illustrated in Table 4. The coat was dried in an oven at 80°C for 60 seconds and thereafter irradiated with ultraviolet light at an irradiation dose of 150 $mJ/cm^2$ using an ultraviolet light irradiation device (manufactured by Fusion UV Systems Japan K.K., light source: H bulb). Accordingly, the coat was cured to form hardcoat layers 1 and 2 having a film thickness after curing of 5.0 $\mu$m illustrated in Table 1 to Table 3. It is noted that the hardcoat layer 2 contains an ultraviolet absorber and thus also serves as an ultraviolet shielding layer.

[Formation of low refractive index layer]

(Composition for forming low refractive index layer)

As a composition for forming a low refractive index layer, the following materials were used.

· Refractive index adjuster:
Dispersion liquid of porous silica fine particles (average particle size: 75 nm, solid content: 20%, solvent: methyl isobutyl ketone) 8.5 parts by mass
· Anti-fouling properties-imparting agent:
Optool AR-110 (manufactured by Daikin Industries Ltd., solid content: 15%, solvent: methyl isobutyl ketone) 5.6 parts by mass
· Active energy ray-curing resin:
Pentaerythritol triacrylate 0.4 part by mass
· Initiator:
Omnirad 184 (manufactured by IGM Resins B.V) 0.07 part by mass
· Leveling agent:
RS-77 (manufactured by DIC Corporation) 1.7 parts by mass
· Solvent:
Methyl isobutyl ketone 83.73 parts by mass

The hardcoat layer illustrated in Table 1 to Table 3 was coated with a composition for forming a low refractive index layer, having the above-described make-up. The coat was dried in an oven at 80°C for 60 seconds and thereafter irradiated with ultraviolet light at an irradiation dose of 200 mJ/$cm^2$ using an ultraviolet light irradiation device (manufactured by Fusion UV Systems Japan KK, light source: H bulb). Accordingly, the coat was cured to form a low refractive index layer having a film thickness after curing of 100 nm illustrated in Table 1 to Table 3.

[Formation of anti-glare layer]

(Composition for forming anti-glare layer)

The following materials were used as a composition for forming an anti-glare layer to prepare the composition illustrated in Table 5.

· Active energy ray-curing resin:
Light Acrylate PE-3A (manufactured by Kyoeisha Chemical Co., Ltd., refractive index: 1.52)

· Photoinitiator:
Omnirad TPO (manufactured by IGM Resins B. V)

· Organic fine particles:
Styrene-methyl methacrylate copolymer particles (refractive index: 1.515, average particle size: 2.0 μm)

· Inorganic fine particles 1:
Synthetic smectite

· Inorganic fine particles 2:
Alumina nanoparticles, average particle size: 40 nm

· Solvent

Toluene

Isopropyl alcohol

[Table 5]

| | | Anti-glare layer 1 |
|---|---|---|
| Active energy ray-curing resin | Type | PE-3A |
| | Amount | 43.7% |
| Organic fine particles | Type Amount | Styrene-methyl methacrylate copolymer particles 0.5% |

(continued)

| | | Anti-glare layer 1 |
|---|---|---|
| Inorganic fine particles | Type | Synthetic smectite/alumina nanoparticles |
| | Ratio | 20/80 |
| | Amount | 1.25% |
| Photoinitiator | Type Amount | Omnirad TPO 4.55% |
| Solvent | Type | Toluene/isopropyl alcohol |
| | Ratio | 30/70 |
| | Amount | 50% |

The transparent substrate of Example 13 illustrated in Table 2 was coated with the composition for forming an anti-glare layer illustrated in Table 5. The coat was dried in an oven at 80°C for 60 seconds and thereafter irradiated with ultraviolet light at an irradiation dose of 150 mJ/cm$^2$ using an ultraviolet light irradiation device (manufactured by Fusion UV Systems Japan KK, light source: H bulb). Accordingly, the coat was cured to form the anti-glare layer having a film thickness after curing of 5.0 μm illustrated in Table 2.

[Formation of first and second adhesive layers]

(Preparation of base adhesive)

The following composition was used as a base adhesive.

· Adhesive resin: solution of butyl acrylate (BA)/hydroxy ethyl methacrylate (HEMA) copolymer dissolved in ethyl acetate 70 parts by mass
· Curing agent: isocyanate-based crosslinking agent 0.037 part by mass
· Additive: silane coupling agent 0.048 part by mass
· Solvent: MEK (methyl ethyl ketone) 30 parts by mass

(Composition for forming first and second adhesive layers)

The following materials of a composition for forming an adhesive layer used in forming the below-described first and second adhesive layers were used to prepare the compositions illustrated in Table 6. It is noted that for the maximum absorption wavelength and half width of the coloring material, characteristic values in the adhesive layer were calculated from a spectral transmittance.

· First coloring material
Dye-1 Pyrromethene cobalt complex dye represented by chemical formula 1 described later (maximum absorption wavelength: 493 nm, half width: 26 nm)
· Second coloring material:
Dye-2 Tetraazaporphyrin copper complex dye (FDG-007 manufactured by Yamada Kagaku Co., Ltd., maximum absorption wavelength: 593 nm, half width: 18 nm)
· Third coloring material:
Dye-3 Phthalocyanine copper complex dye (FDN-002 manufactured by Yamada Kagaku Co., Ltd., maximum absorption wavelength: 800 nm (a wavelength having the lowest transmittance in a wavelength range of 400 to 800 nm is 800 nm.))
· Coloring materials other than first to third coloring materials

Dye-4 (FDG-003 manufactured by Yamada Kagaku Co., Ltd., maximum absorption wavelength: 545 nm, half width: 57 nm)
Dye-5 (FDG-004 manufactured by Yamada Kagaku Co., Ltd., maximum absorption wavelength: 575 nm, half width: 63 μm)

· Additive:

Hindered amine photostabilizer Chimassorb 944FDL (manufactured by BASF Japan Ltd., molecular weight: 2000 to 3100)
Hindered amine photostabilizer Tinuvin 249 (manufactured by BASF Japan Ltd., molecular weight: 482)
Singlet oxygen quencher D1781 (manufactured by Tokyo Chemical Industry Co., Ltd., dialkyl dithiocarbarnate nickel complex)

· Ultraviolet absorber:

Tinuvin 479 (manufactured by BASF Japan Ltd., maximum absorption wavelength: 322 nm)
LA-36 (manufactured by ADEKA Corporation, maximum absorption wavelength: 310 nm, 350 nm)

· Adhesive: base adhesive prepared as described above
· Solvent: ethyl acetate

[Chemical Formula 1]

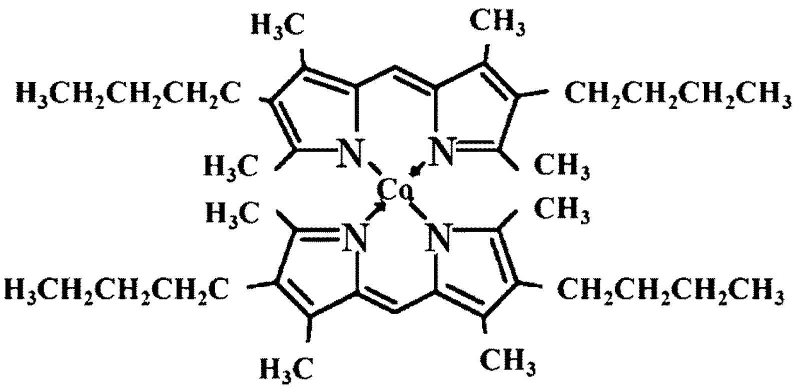

[Table 6]

| | | Adhesive layer 1 | Adhesive layer 2 | Adhesive layer 3 | Adhesive layer 4 | Adhesive layer 5 | Adhesive layer 6 | Adhesive layer 7 | Adhesive layer 8 | Adhesive layer 9 | Adhesive layer 10 | Adhesive layer 11 |
|---|---|---|---|---|---|---|---|---|---|---|---|---|
| Colorant | 1st coloring material | Dye-1 | | | | | | - | - | Dye-1 | - | - |
| | Amount | 0.05% | | | | | 0.01% | - | - | 0.04% | - | - |
| | 2nd coloring material | - | - | - | - | - | - | Dye-2 | - | Dye-2 | - | - |
| | Amount | - | - | - | - | - | - | 0.05% | - | 0.21% | - | - |
| | 3rd coloring material | - | | | | | Dye-3 | - | - | - | - | - |
| | Amount | - | | | | | 0.36% | - | - | - | - | - |
| | Other coloring material | - | - | - | - | - | - | - | - | - | Dye-4 | Dye-5 |
| | Amount | - | - | - | - | - | - | - | - | - | 0.10% | 0.10% |
| Additive | Type | - | Tinuvin 479/LA36 | Chimassorb 944FDL | Tinuvin 249 | Chimassorb 944FDL /D1781 | - | - | Tinuvin 479/LA36 | Chimassorb 944FDL /D1781 | - | - |
| | Ratio | - | 40/60 | 100 | 100 | 67/33 | - | - | 40/60 | 67/33 | - | - |
| | Amount | - | 0.77% | 0.35% | 0.35% | 0.52% | - | - | 0.77% | 0.52% | - | - |
| Adhesive | Amount | 85.61% | 84.51% | 85.11% | 85.11% | 84.87% | 85.15% | 85.61% | 84.58% | 84.58% | 85.54% | 85.54% |
| Ethyl acetate | Amount | 14.34% | 14.67% | 14.49% | 14.49% | 14.56% | 14.48% | 14.34% | 14.65% | 14.65% | 14.36% | 14.36% |

(Production of adhesive layer and optical sheet)

The composition for forming an adhesive layer obtained as described above was applied on a release substrate film so as to have a dried film thickness of 25 μm. The coat was sufficiently dried and thereafter laminated with a release film to obtain an adhesive layer. One of the release films of the obtained adhesive layer was peeled away, and the exposed surface was bonded to a non-alkali glass support body (adherend) having a thickness of 0.7 mm.

Thereafter, the other of the release films of the adhesive layer was peeled away, and the exposed surface was bonded to a substrate laminated with the functional layer illustrated in Table 1 to Table 3 to obtain each of the optical sheets 1 to 22. It is noted that the samples of Examples 1 to 14 and Comparative Examples 1 to 8 are each constituted by bonding the optical sheet to an adherend. The adherend is not particularly limited as long as it is a material that does not hinder the characteristic evaluation of the optical sheet. Materials other than non-alkali glass may also be used.

[Characteristic evaluation of optical sheet]

(Ultraviolet shielding rate of layers above first adhesive layer)

For a laminate as a layer above the first adhesive layer in each of the obtained optical sheets 1 to 18, the transmittance was measured using an automatic spectrophotometer (U-4100, manufactured by Hitachi, Ltd.). Using the transmittance, the average transmittance in the ultraviolet region (290 to 400 nm) was calculated, and the ultraviolet shielding rate illustrated in Equation (2) was calculated.

Equation (2):

Ultraviolet shielding rate (%) = 100 - average transmittance (%) in ultraviolet region (290 to 400 nm)

(Light resistance test)

The reliability test of the obtained optical sheets 1 to 18 was performed as follows. Using a xenon weather meter tester (manufactured by Suga Test Instruments Co., Ltd., X75), the test was performed for 120 hours under the conditions of a xenon lamp illuminance of 60 W/cm$^2$ (300 to 400 nm), a tester chamber temperature of 45°C and humidity of 50% RH. The transmittance was measured before and after the test using an automatic spectrophotometer (U-4100, manufactured by Hitachi, Ltd.) to calculate transmittance difference $\Delta t\lambda$ between before and after the test at wavelength $\lambda$ that exhibits the smallest transmittance in the wavelength ranges of the first coloring material to the third coloring material and color difference ΔE □ ab with illuminant C between before and after the test. The transmittance difference and color difference are good when closer to zero and preferably achieve ΔE □ ab ≤ 5.

The evaluation results of the above-described items are illustrated in Table 7 and Table 8.

[Table 7]

| | | Example 1 | Example 2 | Example 3 | Example 4 | Example 5 | Example 6 | Example 7 | Example 8 | Example 9 |
|---|---|---|---|---|---|---|---|---|---|---|
| Optical sheet | | Optical sheet 1 | Optical sheet 2 | Optical sheet 3 | Optical sheet 4 | Optical sheet 5 | Optical sheet 6 | Optical sheet 7 | Optical sheet 8 | Optical sheet 9 |
| UV shielding rate on 1st adhesive layer | | 92.0% | 91.4% | 93.0% | 93.0% | 93.0% | 93.0% | 93.0% | 93.5% | 88.5% |
| Light resistance of colored layer | $\Delta T\lambda$ | 12.8 | 12.5 | 12.0 | 9.0 | 11.7 | 7.4 | 6.1 | 7.6 | 8.0 |
| | $\Delta Eab$ | 3.6 | 3.5 | 3.3 | 2.8 | 3.3 | 2.6 | 1.5 | 2.6 | 2.7 |

[Table 8]

| | | Example 10 | Example 11 | Example 12 | Example 13 | Example 14 | Comparative Example 1 | Comparative Example 2 | Comparative Example 3 | Comparative Example 4 |
|---|---|---|---|---|---|---|---|---|---|---|
| Optical sheet | | Optical sheet 10 | Optical sheet 11 | Optical sheet 12 | Optical sheet 13 | Optical sheet 14 | Optical sheet 15 | Optical sheet 16 | Optical sheet 17 | Optical sheet 18 |
| UV shielding rate on 1st adhesive layer | | 88.8% | 93.0% | 93.0% | 92.8% | 93.0% | 19.6% | 19.6% | 19.6% | 19.6% |
| Light resistance of colored layer | ΔTλ | 8.1 | 10.1 | 4.0 | 12.1 | 12.3 | 64.2 | 65.4 | 17.8 | 41.2 |
| | ΔEab | 2.7 | 4.0 | 0.7 | 3.3 | 3.3 | 12.1 | 12.5 | 5.1 | 8.0 |

The optical sheets of Examples 1 to 14 include a first adhesive layer (colored adhesive layer) and a layer that is disposed on a side above the first adhesive layer and that has ultraviolet absorption properties. For example, an ultraviolet absorber is contained in the adhesive layer 8 as the second adhesive layer in Example 1 and in the hardcoat layer 2 in Example 2. In Examples 3 to 14, the substrate has an ultraviolet absorption properties. Also, as illustrated in Tables 7 and 8, the layer disposed on a side above the first adhesive layer has an ultraviolet shielding rate of 85% or more.
From the results of Tables 7 and 8, the optical sheet including the colored adhesive layer in the present invention includes, as the upper layer, the ultraviolet shielding layer having an ultraviolet shielding rate of 85% or more, and thus light resistance was drastically improved. Also, as understood from the result of Comparative Example 2, it is difficult to improve light resistance even when an ultraviolet absorber is added to the colored adhesive layer. In this manner, ultraviolet absorption properties have only a small effect when provided to the colored adhesive layer, and another layer needs to be provided as the upper layer.
Light resistance was further improved by further laminating an oxygen barrier layer or by containing, in the colored adhesive layer, at least one of a hindered amine photostabilizer having a high molecular weight as the radical scavenger and a dialkyl dithiocarbarnate nickel complex as the singlet oxygen quencher. It is noted that as understood from the results on the light resistance of the optical sheets containing the adhesive layers 3, 4, and 5, either one or both of the radical scavenger and the singlet oxygen quencher may be added.

[Characteristic evaluation of display device]

In Examples 15 to 17 and Comparative Examples 9 to 12 below, display device characteristics were evaluated by simulation in the following manner for the display devices 1 to 7 which include the obtained optical sheets 6, 11, 12, and 19 to 22. In the simulation, the display devices 1 to 7 were configured such that the optical sheet was bonded to an OLED display device (object).
It is noted that the OLED display device as an object to have the optical sheet bonded has a spectrum illustrated in Fig. 9 during white display and individual spectra illustrated in Fig. 10 during red display, green display, and blue display.

(Transmission characteristics of white display)

The transmittance of the optical sheet obtained was measured using an automatic spectrophotometer (U-4100, manufactured by Hitachi, Ltd.), and the spectrum after transmission through the optical sheet was calculated by multiplying the transmittance of the optical sheet by the single spectrum (shown in Figure 9) of the OLED display device in white display without the optical sheet. The single spectrum of the OLED display device during white display and the spectrum after transmission through the optical sheet were each multiplied by the luminous efficiency function to calculate a Y value. A ratio when the Y value obtained from the spectrum during white display of the OLED display device is 100 was defined as the efficiency, which was evaluated as an indication of the transmission characteristics of the display device.

(Color reproducibility)

The transmittance of the obtained optical sheet was measured using an automatic spectrophotometer (U-4100, manufactured by Hitachi, Ltd.). This transmittance of the optical sheet was multiplied by the individual spectra (illustrated in Fig. 10) during red display, green display, and blue display without transmission through the optical sheet of the OLED display device to calculate respective chromaticities (X,Y) of red, green, and blue single colors according to the CIE (Commission International del'Eclairage) 1931 color system after transmission through the optical sheet. Next, a triangle obtained by connecting the obtained chromaticities of red, green, and blue single colors was compared to each of a triangle connecting three primary colors of red (X = 0.640, Y=0.330), green (X = 0.300, Y = 0.600), and blue (X = 0.150, Y = 0.060) of sRGB defined by the IEC (International Electrotechnical Commission) and a triangle connecting three primary colors of red (X = 0.680, Y = 0.320), green (X = 0.265, Y = 0.690), and blue (X = 0.150, Y = 0.060) of DCI-P3 proposed by the DCI (Digital Cinema Initiatives). The overlapping area was obtained to calculate the coverage ratio of each standard, which was evaluated as an indication of color reproducibility.
As characteristic evaluation with the display devices, white display transmission characteristics and color reproducibility are illustrated in Table 9.

[Table 9]

| | | Example 15 | Example 16 | Example 17 | Comparative Example 9 | Comparative Example 10 | Comparative Example 11 | | Comparative Example 12 |
|---|---|---|---|---|---|---|---|---|---|
| | | Display device 1 | Display device 2 | Display device 3 | Display device 4 | Display device 5 | Display device 6 | | Display device 7 |
| | | Optical sheet 6 | Optical sheet 11 | Optical sheet 12 | Optical sheet 19 | Optical sheet 20 | Optical sheet 21 | | Optical sheet 22 |
| Maximum absorption wavelength (T<50%) | | 493 nm | 800 nm | 593 nm | - | 493 nm | 593 nm | 545 nm | 575 nm |
| Transmittance @maximum absorption wavelength (T<50%) | | 26.3% | 10.1% | 30.5% | - | 37.6% | 4.6% | 30.4% | 30.5% |
| White display characteristic evaluation | | 75 | 69 | 84 | 92 | 62 | 60 | | 66 |
| Color reproducibility evaluation | sRGB coverage ratio | 100% | 99% | 99% | 98% | 100% | 99% | | 99% |
| | DCI coverage ratio | 92% | 89% | 89% | 88% | 93% | 86% | | 88% |

From the results of Table 9, the display devices 1 to 3 (Examples 15 to 17) including the colored adhesive layer as the first adhesive layer in the present invention had an sRGB chromaticity coverage ratio of 99% or more and improved color reproducibility compared to Comparative Example 9 in which a coloring material is not contained in the adhesive layer (the colored adhesive layer is not included).

In Comparative Example 10 having deep absorption in a plurality of wavelength ranges of the first coloring material and the second coloring material, white display transmission characteristics are low. This means that when multiple types of coloring materials are contained in the first adhesive layer, it is preferable that the transmittance is 1% or more and less than 50% in only one of the maximum absorption wavelengths of the coloring materials. Also, in Comparative Examples 11 and 12 including a coloring material that has a wavelength range and a half width that do not meet the requirements, white display transmission characteristics are low. In contrast to these, in Examples 15 to 17, it was demonstrated that white display transmission characteristics are excellent while exhibiting a certain color correction function.

It is noted that the technical scope of the present invention is not limited to the above-described embodiments, which can be variously modified within a scope that does not depart from the spirit of the present invention.

For example, the optical sheet has only to include a first adhesive layer (colored adhesive layer) 10 and a layer that is disposed on a side above the first adhesive layer and has ultraviolet absorption properties. The layer having ultraviolet absorption properties may be the ultraviolet shielding layer 20 or may be the transparent substrate 30 or the optical function layer 50. The layer that is disposed on a side above the first adhesive layer 10 and has ultraviolet absorption properties preferably has an ultraviolet shielding rate according to JIS L 1925 of 85% or more.

Also, the optical sheet may further include an anti-static layer and an anti-fouling layer. Also, the anti-reflection layer in the optical function layer 50 of the optical sheet may include the high refractive index layer, the anti-glare layer 53, and the low refractive index layer 52. At least one of the high refractive index layer, the anti-glare layer 53, and the low refractive index layer 52 may have anti-static properties, and at least one of the high refractive index layer, the anti-glare layer 53, and the low refractive index layer 52 may have anti-fouling properties. For example, an anti-static agent may be added in the high refractive index layer and the anti-glare layer 53 in order to impart anti-static properties. A material having water and/or oil repellency may be contained in the low refractive index layer 52 in order to impart anti-fouling properties to the function of the low refractive index layer 52. Also, anti-fouling properties may be imparted to the high refractive index layer and the anti-glare layer 53. It is noted that both of anti-static properties and anti-fouling properties may be imparted to at least one of the high refractive index layer, the anti-glare layer 53, and the low refractive index layer 52.

This can impart further functions to the optical function layer.

In addition, constituent elements in the above-described embodiments can be appropriately replaced with known constituent elements, or the above-described embodiments and modifications may be appropriately combined, within a scope that does not depart from the spirit of the present invention.

[Industrial Applicability]

The present invention can be used as an optical sheet used in a display device.

[Reference Signs List]

1, 1A, 1B, 1C, 1D, 1E, 1FOptical sheet
10 Colored adhesive layer (first adhesive layer)
20 Ultraviolet shielding layer (ultraviolet absorption adhesive layer, second adhesive layer)
30 Transparent substrate (ultraviolet shielding layer)
40 Oxygen barrier layer
50 Optical function layer
51 Hardcoat layer
52 Low refractive index layer
53 Anti-glare layer
S Separator

## Claims

**1.** An optical sheet comprising:

a first adhesive layer containing an adhesive and a colorant, the first adhesive layer having a first surface and a second surface opposite the first surface; and
an ultraviolet shielding layer arranged to face the first surface of the first adhesive layer, wherein
the colorant contains at least one of

a first coloring material having a maximum absorption wavelength in a range of 470 to 530 nm and an absorption spectral half width of 15 to 45 nm,
a second coloring material having a maximum absorption wavelength in a range of 560 to 620 nm and an absorption spectral half width of 15 to 55 nm, and
a third coloring material in which a wavelength having the lowest transmittance in a wavelength range of 400 to 800 nm is in a range of 650 to 800 nm,

in the first adhesive layer, one of absorption wavelength bands of the colorant includes a maximum absorption wavelength at which a transmittance is 1% or more and less than 50%,
the ultraviolet shielding layer has an ultraviolet shielding rate according to JIS L 1925 of 85% or more, and
ΔE □ ab, which is a chromaticity difference between before and after a light resistance test of irradiating for 120 hours with a xenon lamp having an illuminance at wavelengths of 300 to 400 nm of 60 $W/cm^2$ at a temperature of 45°C and a humidity of 50% RH, satisfies Equation (1) below:

$$\Delta E \square ab \leq 5 \qquad \text{Equation (1).}$$

**2.** The optical sheet according to claim 1, wherein the first adhesive layer contains at least one of a radical scavenger, a peroxide decomposer, and a singlet oxygen quencher.

**3.** The optical sheet according to claim 2, wherein the radical scavenger is a hindered amine photostabilizer having a molecular weight of 2,000 or more.

**4.** The optical sheet according to claim 2, wherein the singlet oxygen quencher is a transition metal complex of dialkyl phosphate, dialkyl dithiocarbamate, or benzene dithiol or similar dithiol.

**5.** The optical sheet according to any one of claims 1 to 4, wherein the colorant contained in the first adhesive layer includes one or more compounds selected from the group consisting of a compound having any of porphyrin structure, merocyanine structure, phthalocyanine structure, azo structure, cyanine structure, squarylium structure, coumarin structure, polyene structure, quinone structure, tetradiporphyrin structure, pyrromethene structure, and indigo structure, and a metal complex thereof.

**6.** The optical sheet according to any one of claims 1 to 5, wherein the ultraviolet shielding layer is a second adhesive layer that contains an adhesive and an ultraviolet absorber.

**7.** The optical sheet according to any one of claims 1 to 5, wherein the ultraviolet shielding layer is a transparent substrate.

**8.** The optical sheet according to any one of claims 1 to 7, further comprising an oxygen barrier layer having an oxygen permeability of 10 cc/($m^2$·day·atm) or less, the oxygen barrier layer being arranged to face the first surface of the first adhesive layer.

**9.** The optical sheet according to any one of claims 1 to 8, further comprising, as a layer above the ultraviolet shielding layer, an optical function layer that reduces reflection of incident external light, wherein
the optical function layer includes at least one of

an anti-reflection layer that contains a high refractive index layer and a low refractive index layer,
an anti-reflection layer that contains a high refractive index layer and an anti-glare layer,
an anti-reflection layer that contains a high refractive index layer, an anti-glare layer, and a low refractive index layer, and
an anti-reflection layer that contains an anti-glare layer.

**10.** The optical sheet according to any one of claims 1 to 9, further comprising an anti-static layer or an anti-fouling layer.

**11.** The optical sheet according to claim 9, wherein

at least one of the high refractive index layer, the anti-glare layer, and the low refractive index layer further has anti-static properties, and
at least one of the high refractive index layer, the anti-glare layer, and the low refractive index layer further has anti-fouling properties.

**12.** A display device comprising the optical sheet according to any one of claims 1 to 11.

FIG.1

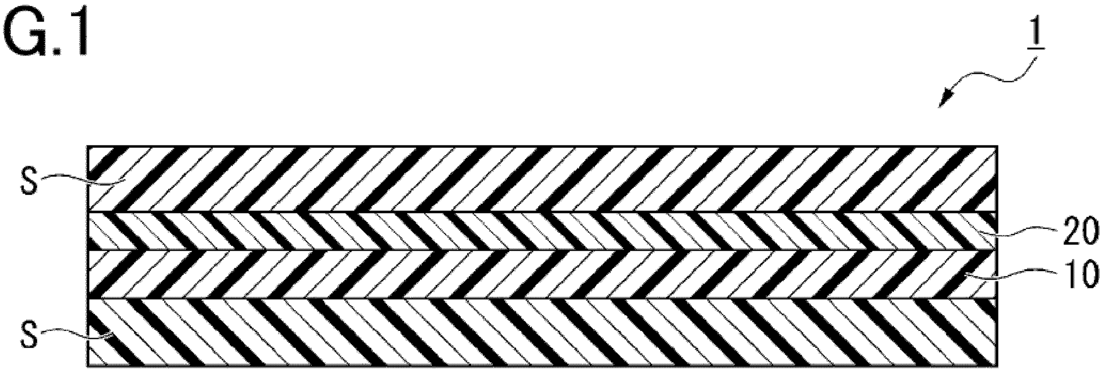


FIG.2

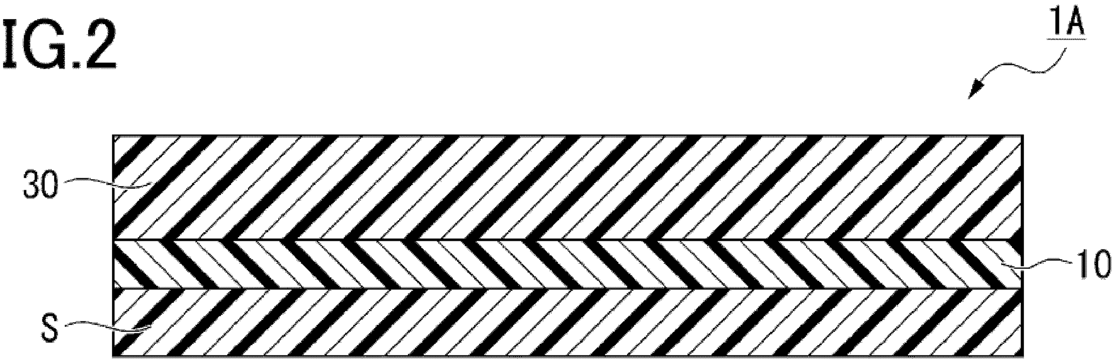


FIG.3

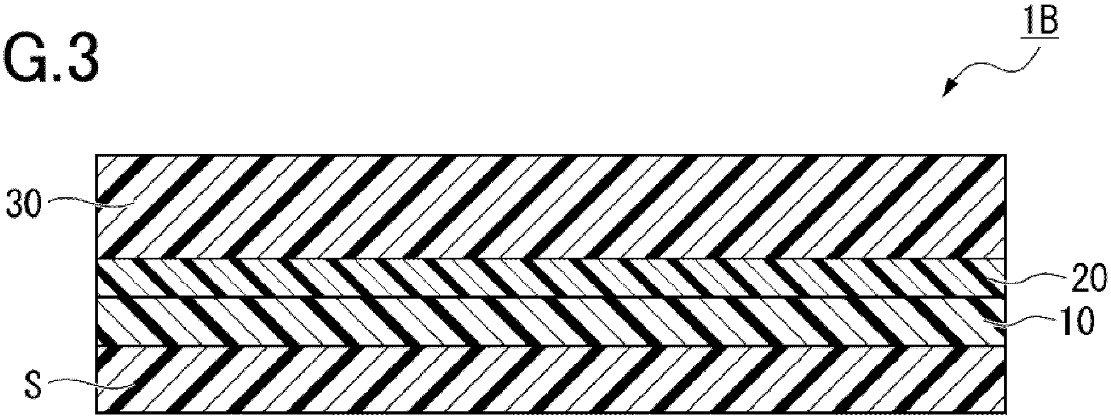


FIG.4

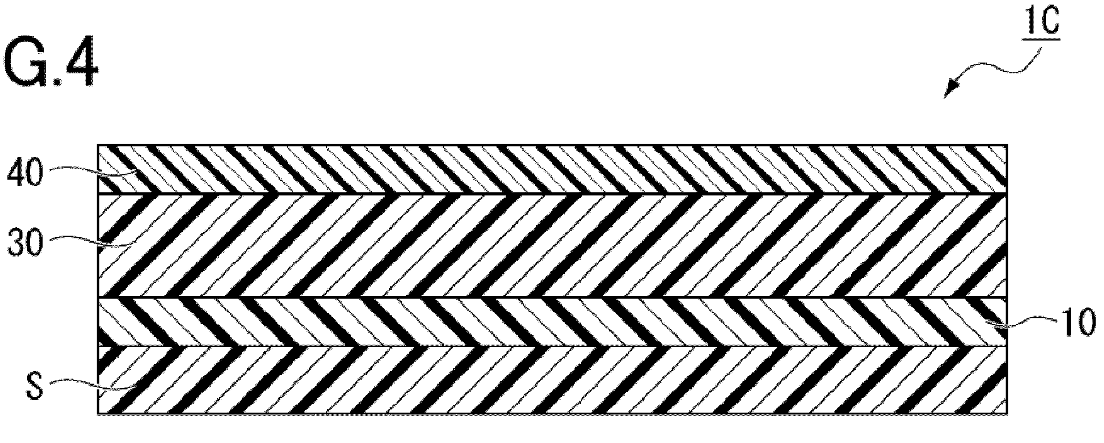

FIG.5

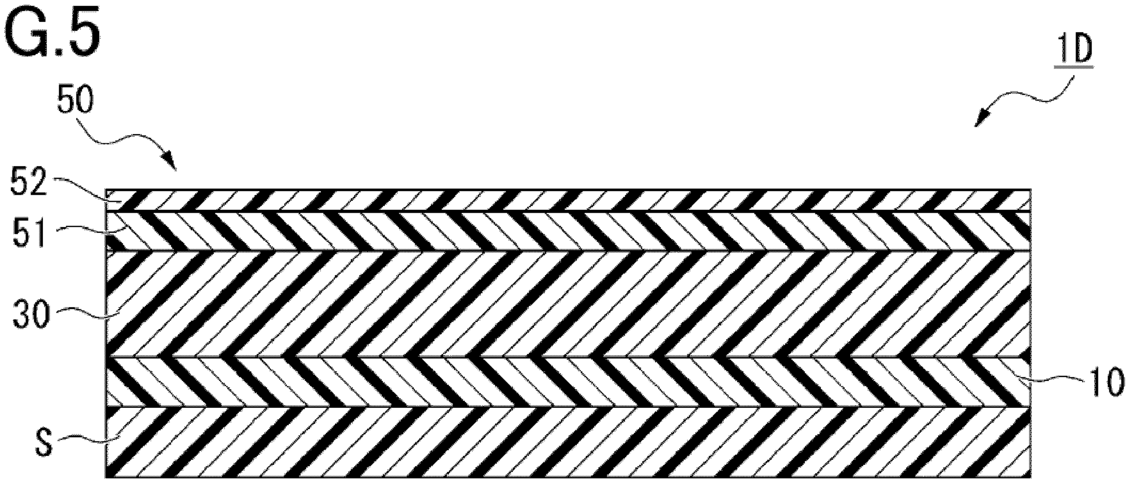


FIG.6

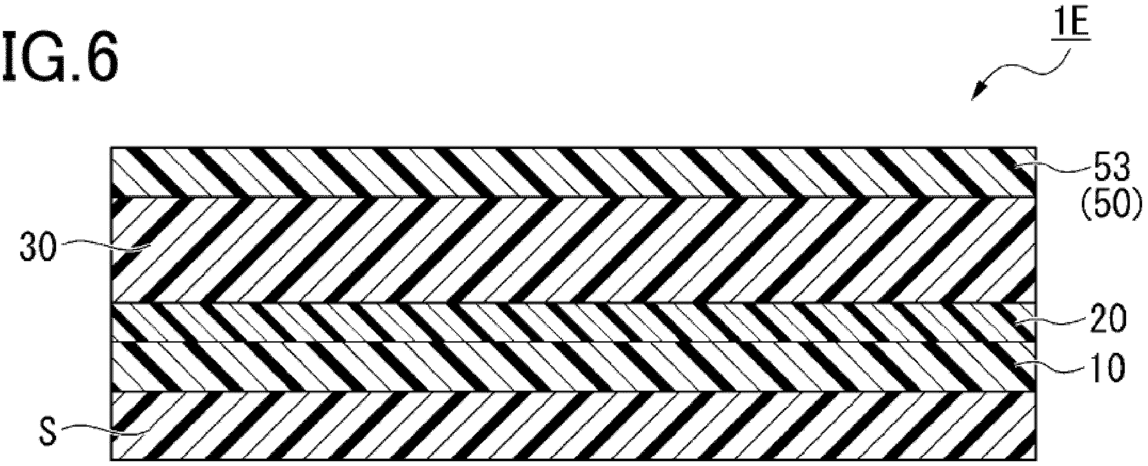


FIG.7

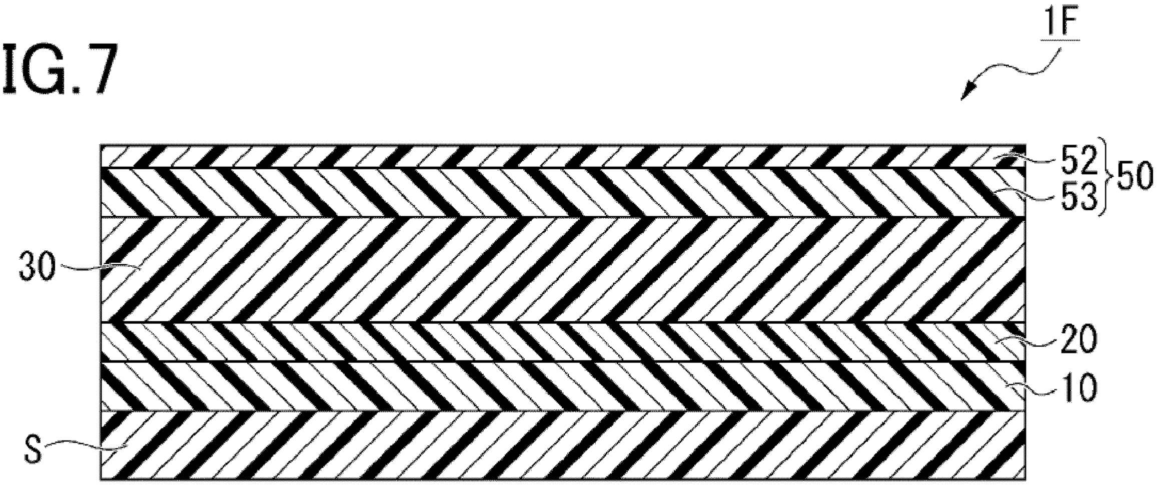

FIG.8

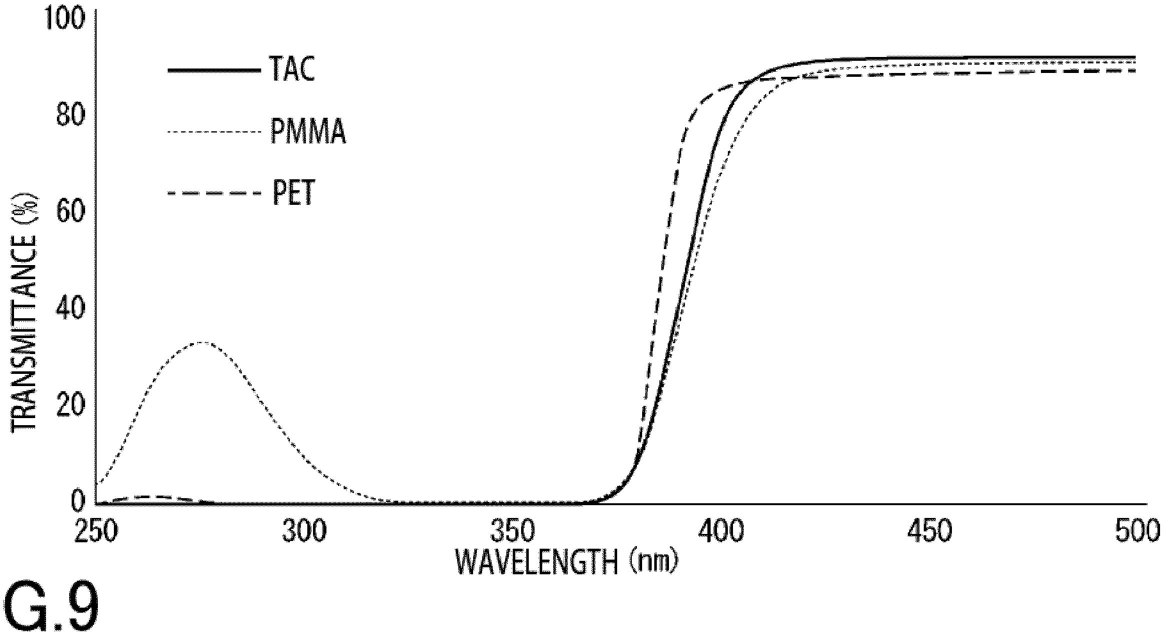
100
80
60
40
20
0
TRANSMITTANCE (%)
TAC
PMMA
PET
250
300
350
400
450
500
WAVELENGTH (nm)

FIG.9

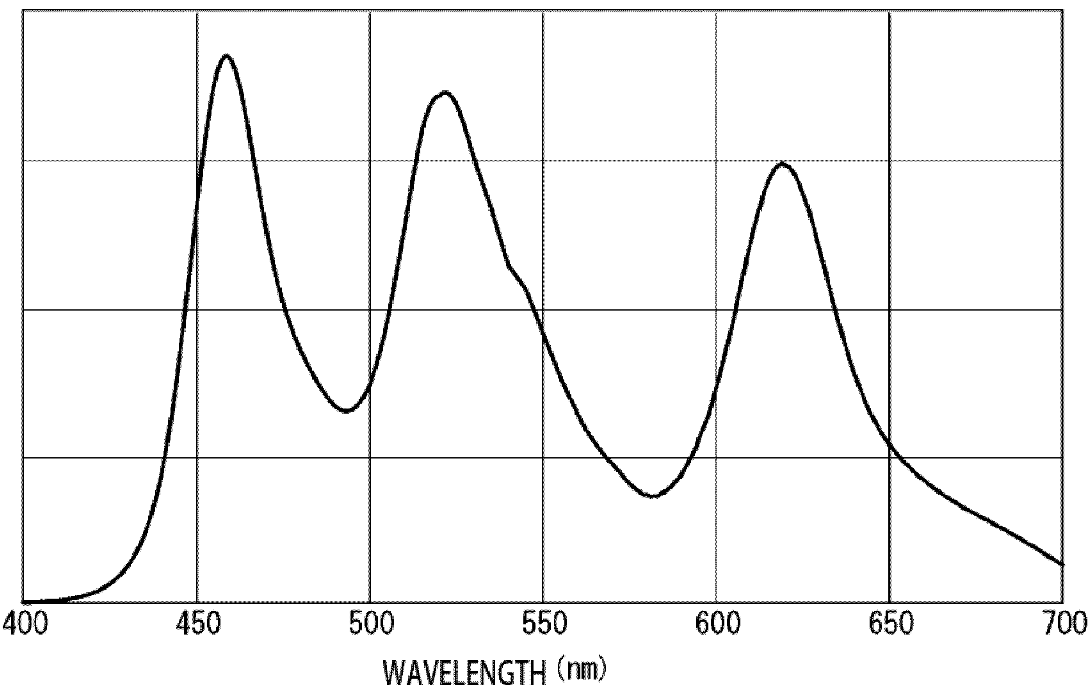
400
450
500
550
600
650
700
WAVELENGTH (nm)

FIG.10

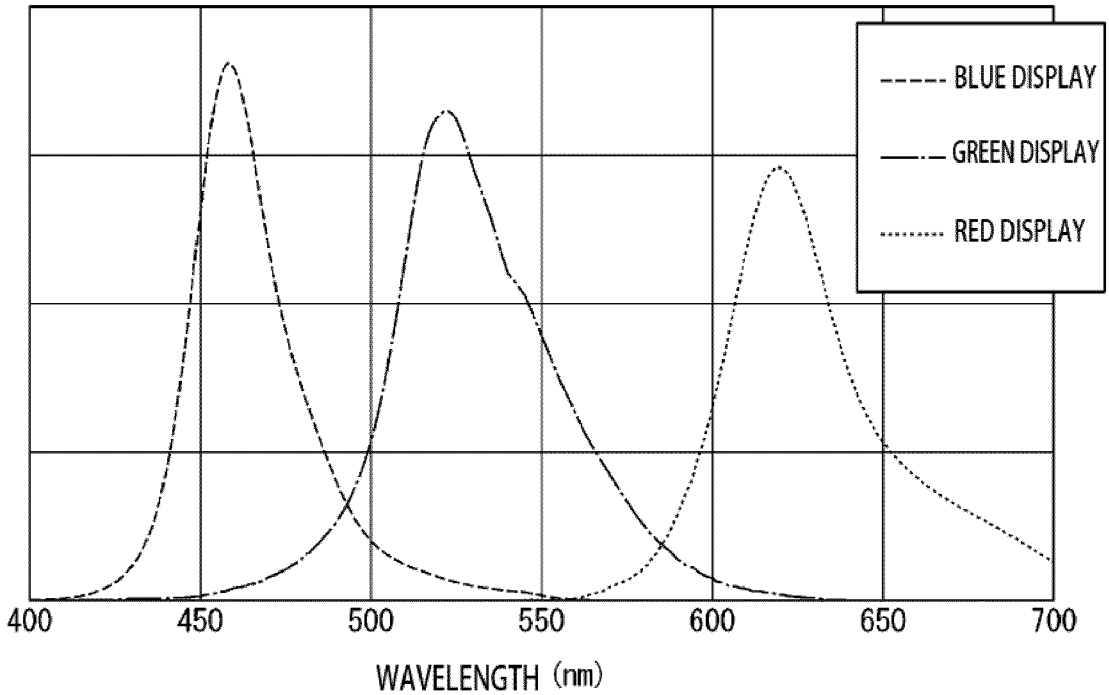
BLUE DISPLAY
GREEN DISPLAY
RED DISPLAY
400
450
500
550
600
650
700
WAVELENGTH (nm)

## INTERNATIONAL SEARCH REPORT

International application No.
PCT/JP2021/026647

A. CLASSIFICATION OF SUBJECT MATTER
G02B 5/22(2006.01)i; G02B 1/116(2015.01)i; G02B 1/16(2015.01)i; G02B 1/18(2015.01)i; G02B 5/02(2006.01)i; G02F 1/1335(2006.01)i; G09F 9/00(2006.01)i
FI: G02B5/22; G02F1/1335 505; G09F9/00 313; G02B1/116; G02B1/16; G02B1/18; G02B5/02
According to International Patent Classification (IPC) or to both national classification and IPC

B. FIELDS SEARCHED
Minimum documentation searched (classification system followed by classification symbols)
G02B5/22; G02B1/116; G02B1/16; G02B1/18; G02B5/02; G02F1/1335; G09F9/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2006/118277 A1 (MITSUBISHI CHEMICAL CORP.) 09 November 2006 (2006-11-09) paragraphs [0001], [0163]-[0164], [0183], [0236], [0256], fig. 23 | 1, 5, 7, 9-10, 12<br>2-4, 6, 8, 11 |
| Y | JP 2019-56865 A (TOMOEGAWA CO., LTD.) 11 April 2019 (2019-04-11) paragraphs [0014], [0073], [0079], [0083], [0141], [0142], [0147] | 1-12 |
| Y | JP 2001-147319 A (FUJI PHOTO FILM CO., LTD.) 29 May 2001 (2001-05-29) paragraph [0231] | 1-12 |
| Y | JP 2018-136361 A (TOYO INK SC HOLDINGS CO., LTD.) 30 August 2018 (2018-08-30) paragraph [0117] | 2-3 |
| Y | JP 2011-141356 A (TOPPAN PRINTING CO., LTD.) 21 July 2011 (2011-07-21) paragraphs [0007], [0101] | 4 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 August 2021 (26.08.2021) | 07 September 2021 (07.09.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No. PCT/JP2021/026647

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2009-115882 A (TORAY INDUSTRIES, INC.) 28 May 2009 (2009-05-28) paragraph [0104] | 6 |
| Y | JP 2009-31733 A (NITTO DENKO CORP.) 12 February 2009 (2009-02-12) paragraphs [0010], [0019], [0073], fig. 2 | 8 |
| Y | JP 2010-61066 A (TORAY INDUSTRIES, INC.) 18 March 2010 (2010-03-18) paragraph [0021] | 11 |

Form PCT/ISA/210 (continuation of second sheet) (January 2015)

**INTERNATIONAL SEARCH REPORT**
Information on patent family members

International application No.
PCT/JP2021/026647

| Patent Documents referred in the Report | Publication Date | Patent Family | Publication Date |
|---|---|---|---|
| WO 2006/118277 A1 | 09 Nov. 2006 | US 2009/0029135 A1 paragraphs [0001], [0290]-[0293], [0325]-[0326], [0420], [0461], fig. 23<br>EP 1876212 A1<br>CN 101163771 A<br>KR 10-2008-0011158 A<br>KR 10-1011964 B1 | |
| JP 2019-56865 A | 11 Apr. 2019 | (Family: none) | |
| JP 2001-147319 A | 29 May 2001 | US 6307671 B1 column 78, lines 28-61 | |
| JP 2018-136361 A | 30 Aug. 2018 | (Family: none) | |
| JP 2011-141356 A | 21 Jul. 2011 | (Family: none) | |
| JP 2009-115882 A | 28 May 2009 | (Family: none) | |
| JP 2009-31733 A | 12 Feb. 2009 | US 2010/0103355 A1 paragraphs [0008], [0024], [0082], fig. 2<br>KR 10-2009-0035468 A<br>CN 101542329 A<br>TW 200902635 A | |
| JP 2010-61066 A | 18 Mar. 2010 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021006750 A
- JP 2019056865 A
- JP 5917659 B